# EUROPEAN PATENT SPECIFICATION

(11) **EP 0 778 622 B1**
(45) Date of publication and mention of the grant of the patent: **08.09.1999**
(21) Application number: 96118722.6
(22) Date of filing: 21.11.1996
(51) Int. Cl.: H01L 29/737, H01L 29/73, H01L 29/08

(54) **Heterojunction bipolar transistor**
Bipolartransistor mit Heteroübergang
Transistor bipolaire à hétérojonction

(30) Priority: 08.12.1995 JP 32035695
(43) Date of publication of application: 11.06.1997
(73) Proprietor: MITSUBISHI DENKI KABUSHIKI KAISHA, Tokyo 100 (JP)
(72) Inventor: Uneme, Yutaka, Chiyoda-ku, Tokyo 100 (JP); Kadoiwa, Kaoru, Chiyoda-ku, Tokyo 100 (JP); Hayafuji, Norio, Chiyoda-ku, Tokyo 100 (JP); Shimamura, Teruyuki, Chiyoda-ku, Tokyo 100 (JP)
(74) Representative: Winter, Brandl, Fürniss, Hübner, Röss, Kaiser, Polte, Kindermann Partnerschaft

(56) References cited:
- EP-A- 0 630 053
- US-A- 5 289 020
- US-A- 5 389 554
- SOLID STATE ELECTRONICS, vol. 38, no. 9, 1995, pages 1657-1661, XP000614943 TWYNAM J K ET AL: "THERMAL STABILIZATION OF ALGAAS/GAAS POWER HBTS USING N-ALCGA1-XAS EMITTER BALLAST RESISTORS WITH HIGH THERMAL COEFFICIENT OF RESISTANCE"

## Description

The present invention relates to a heterojunction bipolar transistor (HBT) according to the preamble of claim 1; the present invention particularly relates to a high power output HBT including a ballast resistor layer being disposed between an emitter layer and an emitter electrode.

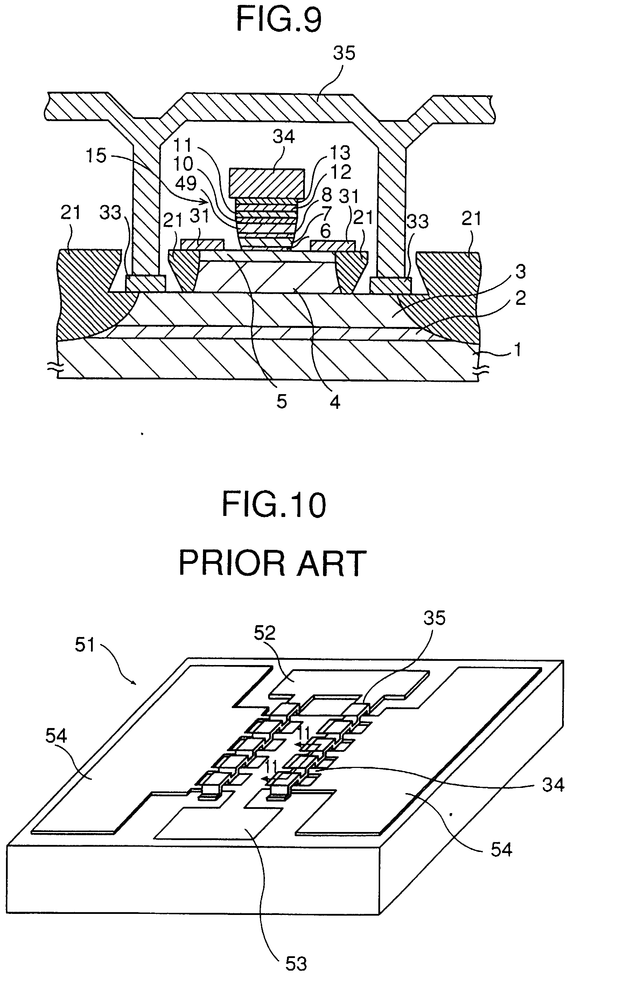

Fig.10 is a perspective view of a prior art high power output HBT structure 51 including a collector terminal 52, a base terminal 53, two emitter terminals 54, and an air bridge electrode 35. As is apparent from Fig.10, the HBT structure includes a plurality of HBT unit transistors that are electrically connected in parallel so as to increase the output power.

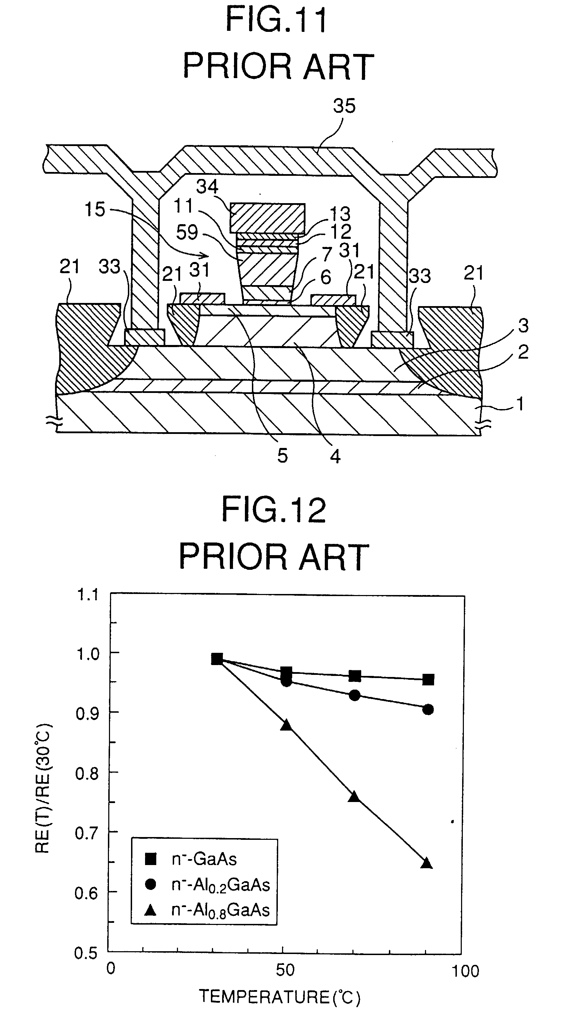

Fig.11 is a cross-sectional view taken along the line 11-11 of Fig.10 showing one complete HBT unit transistor 15 of the HBT structure 51. Each unit transistor 15 of the structure includes a part of a semi-insulating GaAs substrate and, successively disposed on that part of the substrate, a buffer layer 2, an n⁺-type GaAs sub-collector layer 3, an n-type GaAs collector layer 4, and a p⁺-type GaAs base layer 5. These laminated layers have a mesa configuration in cross-section that is defined by electrically insulating regions 21 disposed at respective sides of the mesa. Collector electrodes 33 are disposed on the surface of the n⁺-type sub-collector layer 3 and are connected to each other by the air bridge electrode 35. The unit transistor 15 also includes, successively disposed on part of the p⁺-type GaAs base layer 5, an n-type AlGaAs layer 6, an n-type Al_{0.26}Ga_{0.74}As emitter layer 7, an n-type AlₓGa₁₋ₓAs ballast resistor layer 59, an n⁺-type GaAs spacer layer 11, an n-type InGaAs layer 12, and an n⁺-type In_{0.5}Ga_{0.5}As emitter contact layer 13. These laminated layers have an inverted mesa configuration in cross-section and are centrally disposed on the surface of the base layer 5. Base electrodes 31 are disposed on the surface of the base layer 5 at opposite sides of the inverted mesa configuration and are electrically connected to the emitter terminal 54 shown in Fig.10.

The structure of Fig.10 includes ten unit transistors 15 electrically connected in parallel and disposed between the emitter terminals 54 and the collector terminal 52. Although the parallel interconnection provides a high power output, some of the characteristics of the individual unit transistors 15 may not be identical so that it is difficult to drive each of the unit transistors uniformly. During non-uniform operation, a larger amount of current may flow through one of the unit transistors than through others, causing an increased operating temperature and ultimately resulting in thermal runaway and destruction of the HBT structure 51. The problem of thermal runaway has been controlled in the prior art by adding the ballast resistor layer 59 between the emitter layer 7 and an emitter electrode 34, as shown in Fig.11. The ballast resistor layer 59 helps to maintain a uniform current flow in each of the unit transistors 15.

In the structure of Fig.11, AlₓGa₁₋ₓAs is employed as the material of the ballast resistor layer 59. However, GaAs may also be employed as the ballast resistor layer provided that the dopant concentration of the GaAs is relatively low so as to produce the desired ballast resistance. See Ueda et al., Electronics Letters, Volume 25, pages 1268-1269 (1989). To produce a desired resistance with a GaAs ballast resistor layer, the charge carrier concentration of the layer is desirably 10¹⁶ cm⁻³ and the thickness is about 200 nanometers (nm). The low charge carrier concentration is employed so that the surface depletion layer in the ballast resistor layer is relatively wide and confines the current that flows to the emitter. The ballast resistor layer is preferably relatively thick so that the cross-sectional area is not undesirably reduced during processing. Since the charge carrier concentration is relatively low, the resistance of the ballast resistor layer depends upon the quantity of electrons that are injected into it, i.e., the resistance varies with current flow rather than having a stable value.

In order to produce the transistor structure of Fig.11, the surface of the base layer must be exposed so that the base electrodes 31 can make contact to that layer. As the thickness of the ballast resistor layer increases, the amount of etching required to expose the surface of the base layer is also increased, resulting in difficulties in maintaining the desired reverse mesa shape, cross-sectional area of the ballast resistor layer, and the desired exposure of the base layer. The resulting processing variations interfere with reliable exposure of the base layer and the uniformity of the base resistances of the unit transistors 15.

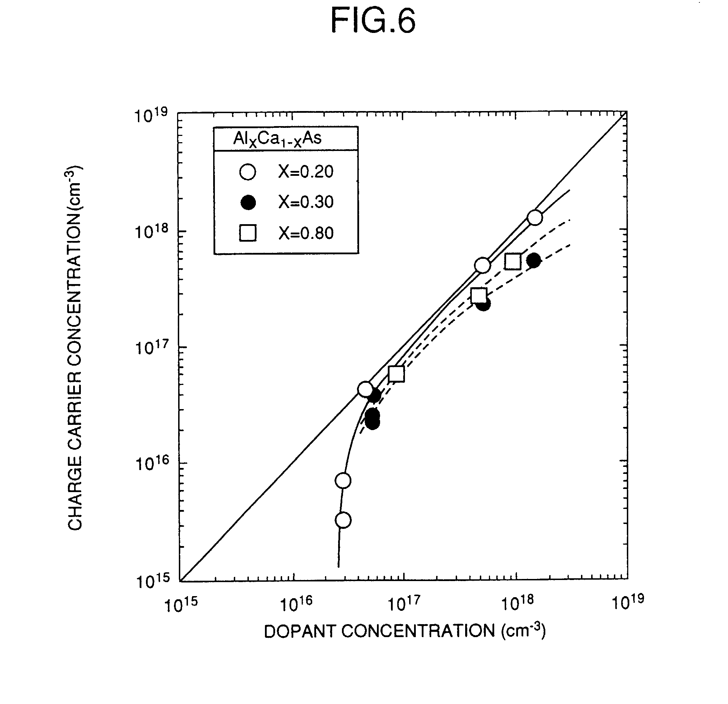

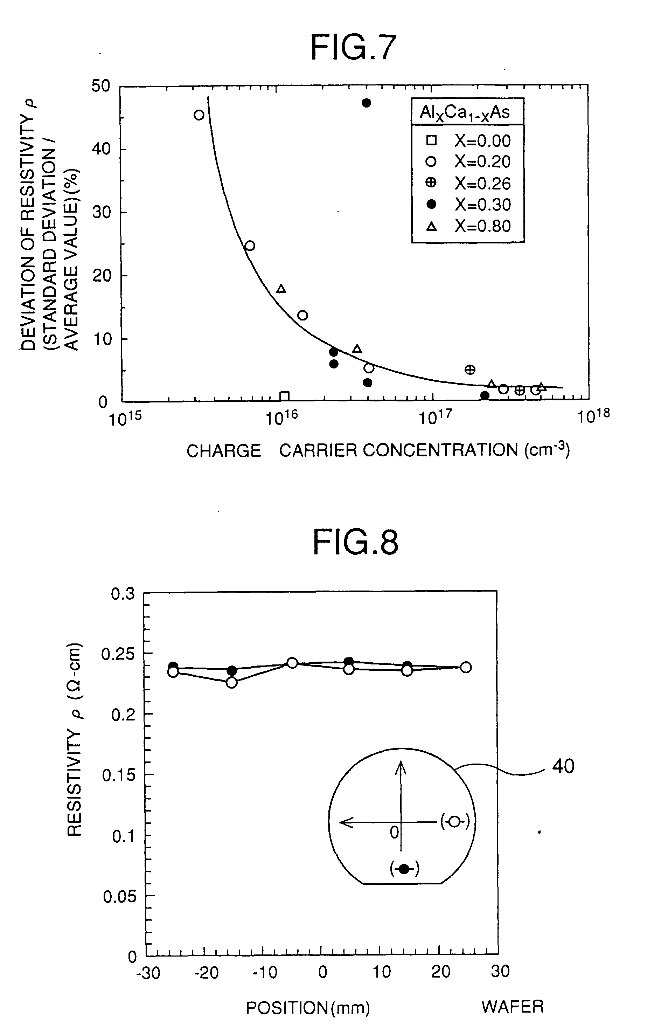

When the ballast resistor layer is AlₓGa₁₋ₓAs, as in the structure of Fig.11, other difficulties arise. An example of an AlₓGa₁₋ₓAs ballast resistor layer where x ranges from 0.2 to 0.35 is described by Twynam et al., Abstracts Of Topical Workshop On Heterostructure Microelectronics, pages 64-65 (1994). Since electron mobility is relatively large in AlGaAs when x ranges from 0.2 to 0.35, just as in GaAs when x = 0, the charge carrier concentration must be kept at about 10¹⁶ cm⁻³ in order to control the resistance of the ballast resistor layer, i.e., to produce a resistivity from which a resistance of the desired value can be obtained. Fig.6 depicts the relationship between dopant concentration and charge carrier concentration in AlₓGa₁₋ₓAs with x as a parameter. As shown in Fig.6, when the dopant concentration is at least 10¹⁷ cm⁻³ at room temperature, the charge carrier concentration is almost proportional to the dopant concentration. However, when the dopant concentration falls below about 5x10¹⁶ cm⁻³, the charge carrier concentration falls dramatically because of the residual impurities in the AlGaAs. Therefore, it is very difficult to control the charge carrier concentration at levels of about 10¹⁶ cm⁻³. In addition, as shown in Fig.7, in which the deviation of the resistivity of AlₓGa₁₋ₓAs as a function of charge carrier concentration, with x as a parameter, is plotted, when the charge carrier concentration is no larger than 10¹⁶ cm⁻³, the deviation of the resistivity varies very steeply as a function of charge carrier concentration. This rapid variation in the resistivity deviation is a further indication of the difficulty of controlling the resistivity of AlGaAs when the charge carrier concentration is very low.

An example of an AlₓGa₁₋ₓAs ballast resistor layer with x greater than 0.4 is described in US-A-5,389,554 which constituter the preamble of claim 1. In material of this composition, since the electron mobility is relatively low, it is not necessary to limit the charge carrier concentration to about 10¹⁶ cm⁻³ to obtain a desired resistance of the ballast resistor. However, in the HBT structure 51, with a GaAs layer located contiguous to the AlₓGa₁₋ₓAs ballast resistor layer, the discontinuity of the energy band edges at the interface of the ballast resistor layer and the GaAs layer is relatively large. That large discontinuity affects the electrical characteristics of the HBT. The effects of temperature are illustrated in Fig.12 in which the resistance of the ballast resistor at the temperature, T, normalized, i.e., divided by, the resistance at 30°C, r(30°C), is plotted on the ordinate as a function of the temperature, T, plotted on the abscissa. The normalized temperature variation is plotted for three different Al concentrations, i.e., x = 0, x = 0.2, and x = 0.8. Fig.12 shows that the resistance variation with temperature is relatively small when x = 0 and 0.2 but that the temperature dependency of the resistance is much larger when x = 0.8.

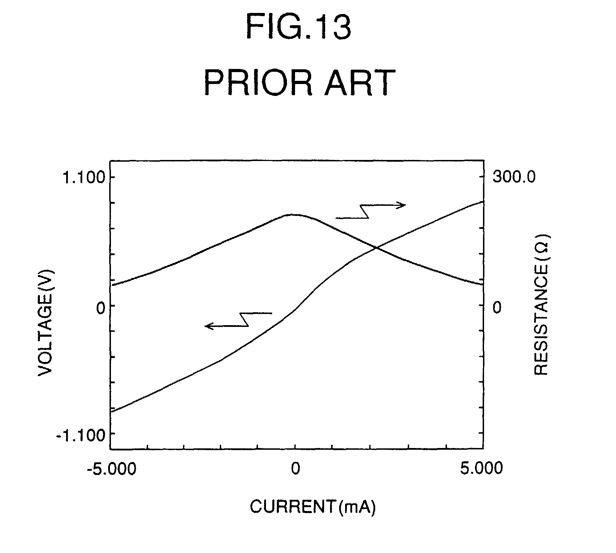

Fig.13 is a graph showing the variation of resistance and voltage across an Al_{0.3}Ga_{0.2}As ballast resistor layer as a function of current flowing through the layer. Fig.13 shows that the ballast resistor layer exhibits a negative resistance, i.e., a reduction in voltage for an increase in current flow, i.e., a reduction in resistance as current increases. The negative resistance results from the variation in the ballast resistance with current because of the low charge carrier concentration of the ballast resistor layer. The temperature dependence and the negative resistance characteristic contribute to non-uniform operation of the unit transistors 15 of the HBT structure 51, adversely affecting the purpose of the ballast resistor layer, i.e., stable operation free of thermal runaway.

US-5 289 020 discloses a heterojunction bipolar transistor having first and second emitter layers. Said second emitter layer consists of AlₓGa₁₋ₓAs having an Al composition of 0.6 which is greater than the Al composition of said first emitter layer.

EP-A-0 630 053 discloses a heterojunction bipolar transistor having a ballast resistance layer consisting of Al_{y}Ga_{1-y}As having an Al composition of 0 < y ≤ 0.45. This ballast resistance layer having a charge carrier concentration of 10¹⁷ cm⁻³. The Al concentration in the n-Al_{y}Ga_{1-y}As ballast resistance layer has only to be in the range of 0 < y ≤ 0.45, more preferably in the range of 0.2 < y ≤ 0.45, and the most preferably y = 0.35.

It is the object of the present invention to provide an HBT which is optimally suited for the formation of a plurality of unit transistors so as to provide a uniform operation of these unit transistors.

This object, according to the invention, is solved by the advantageous measures of claim 1.

Further developments of the invention are subject-matter of the subclaims.

Other objects and advantages of the present invention will become apparent from the detailed description that follows. In the Drawings
Fig.1 is a cross-sectional view of a part of a HBT structure for elucidating an essential feature of the invention;
Figs. 2(a)-2(g) are cross-sectional views illustrating a method of fabricating the HBT structure shown in Fig.1;
Fig.3 is a graph of charge carrier concentration and electron mobility as a function of x in an n-type AlₓGa₁₋ₓAs semiconductor layer;
Fig.4 is a graph of resistivity as a function of x of an n-type AlₓGa₁₋ₓAs semiconductor layer;
Fig.5 is a cross-sectional view of a part of a HBT structure for elucidating a further essential feature of the invention;
Fig.6 is a graph of charge carrier concentration as a function of dopant concentration for an n-type AlₓGa₁₋ₓAs semiconductor layer with x as a parameter;
Fig.7 is a graph showing the deviation of resistivity of n-type AlₓGa₁₋ₓAs as a function of charge carrier concentration with x as a parameter;
Fig.8 is a graph of the resistivity of a ballast resistor layer shown in Fig.5 as a function of position on a surface of the layer;
Fig.9 is a cross-sectional view of a part of an HBT structure according to an embodiment of the invention;
Fig.10 is a perspective view of a prior art HBT structure;
Fig.11 is a cross-sectional view of a part of the prior art HBT structure;
Fig.12 is a graph of the temperature dependency of the resistance of a ballast resistor layer of AlₓGa₁₋ₓAs as a function of temperature in the prior art HBT with x as a parameter; and
Fig.13 is a graph of the voltage across and the resistance of a ballast resistor layer as a function of current flowing through the layer in the prior art HBT.

It further is to be noted that, in all figures, the same elements are given the same reference numbers.

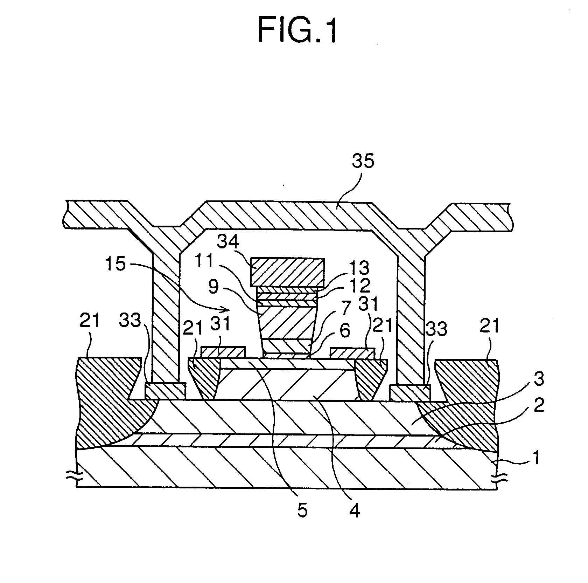

Fig.1 is a cross-sectional view of a part of a HBT structure for elucidating an essential feature of the invention. A unit transistor 15 of the structure is shown in Fig.1 in cross-section. The HBT structure includes a semi-insulating GaAs substrate 1 on which are successively disposed a buffer layer 2 of undoped GaAs, a superlattice layer, or a combination of both. An n⁺-type GaAs sub-collector layer 3 having a dopant concentration of 5x10¹⁸ cm⁻³ and 500 nm thick is disposed on the buffer layer 2. An n-type GaAs collector layer 4 having a dopant concentration of 3x10¹⁶ cm⁻³ and 700 nm thick is disposed on the layer 3. A p⁺-type GaAs base layer 5 having a dopant concentration of 4x10¹⁹ cm⁻³ and 70 nm thick is disposed on the collector layer 4 and connected to base electrodes 31. The buffer layer 2, the subcollector layer 3, the collector layer 4, and the base layer 5 have a mesa configuration in cross-section that is confined at opposite sides by respective electrically insulating regions 21. Collector electrodes 33 are disposed on the surface of the sub-collector layer 3 and are connected together by an air bridge electrode 35.

A graded composition n-type AlGaAs layer 6 having a dopant concentration of 10¹⁸ cm⁻³, 26 nm thick, and having an Al composition that gradually varies from 0 to 0.26 is disposed on the base layer 5. An n-type Al_{0.26}Ga_{0.74}As emitter layer 7 having a dopant concentration of 10¹⁹ cm⁻³ and a thickness of 90 nm is disposed on the graded layer 6. An n-type AlₓGa₁₋ₓAs ballast resistor layer 9, where 0.5 ≤ x ≤ 1, and having a thickness of 100 nm is disposed on the emitter layer 7. In this structure, x = 0.8. An n⁺-type GaAs spacer layer 11 having a dopant concentration of 5x10¹⁸ cm⁻³ and 30 nm thick is disposed on the ballast resistor layer 9. A graded composition n-type InGaAs layer 12, 50 nm thick, having an In composition varying from 0 to 0.5 and a charge carrier concentration gradually changing from 5x10¹⁸ cm⁻³ to 4x10¹⁹ cm⁻³ is disposed on the spacer layer 11. An n⁺-type In_{0.5}Ga_{0.5}As emitter contact layer 13 having a dopant concentration of 4x10¹⁹ cm⁻³ and 50 nm thick is disposed on the layer 12 and is connected to the emitter electrode 34. Each unit transistor 15 includes the successively arranged layers from layer 3 through layer 13.

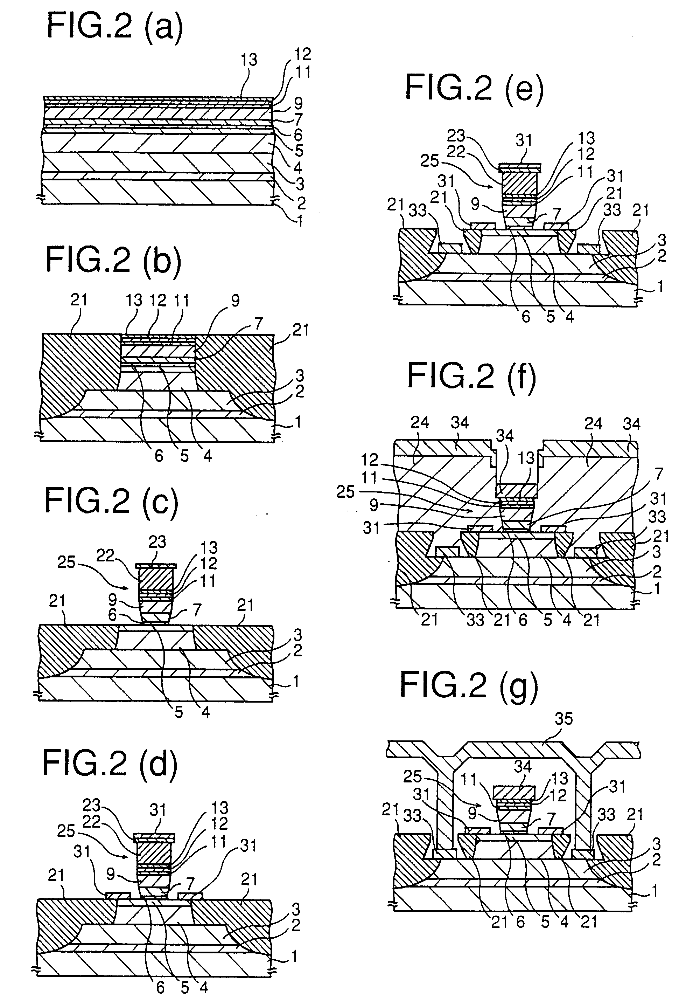

A method of fabricating the HBT structure illustrated in Fig.1 is shown in Figs. 2(a)-2(g). Initially, as indicated in Fig.2(a), the buffer layer 2, the n⁺-type GaAs sub-collector layer 3, the n-type GaAs collector layer 4, the p⁺-type GaAs base layer 5, the n-type AlGaAs layer 6, the n-type Al_{0.26}Ga_{0.74}As emitter layer 7, the n-type Al_{0.8}Ga_{0.2}As ballast resistor layer 9, the n⁺-type GaAs spacer layer 11, the n-type InGaAs layer 12, and the n⁺-type In_{0.5}Ga_{0.5}As emitter contact layer 13 are successively epitaxially grown on the substrate 1.

As shown in Fig.2(b), the electrically insulating regions 21 are formed by ion implantation in which the ions penetrate the semiconductor layers 213. An SiON film 22 that is a dummy emitter and a WSi film 23 are formed on a region of the emitter contact layer 13. Using the SiON film 22 and the WSi film 23 as masks, the semiconductor layers 2-13 and the electrically insulating regions 21 are etched until the surface of the base layer 5 is exposed. The etching produces an emitter mesa 25, as shown in Fig.2(c).

Further, using the SiON film 22 and the WSi film 23 as masks, the base electrodes 31 are formed on the base layer 5, as shown in Fig.2(d), using a conventional electrode-forming process. The base electrode 31 is left in place on the WSi film 23.

Limited areas of the electrically insulating regions 21 are removed by etching and the collector electrode 33 is formed on the n⁺-type GaAs layer 3, as shown in Fig.2(e).

The entire substrate is covered with a resist 24 and then the SiON film 22, the WSi film 23, and the remaining base electrode 31 are removed from the emitter mesa 25, as shown in Fig.2(f). The resist 24 and unprotected portions of the emitter electrode layer 34 are removed. As shown in Fig.2(g), the air bridge electrode 35 connects the collector electrodes 33 to collector terminals that are not shown in the figures.

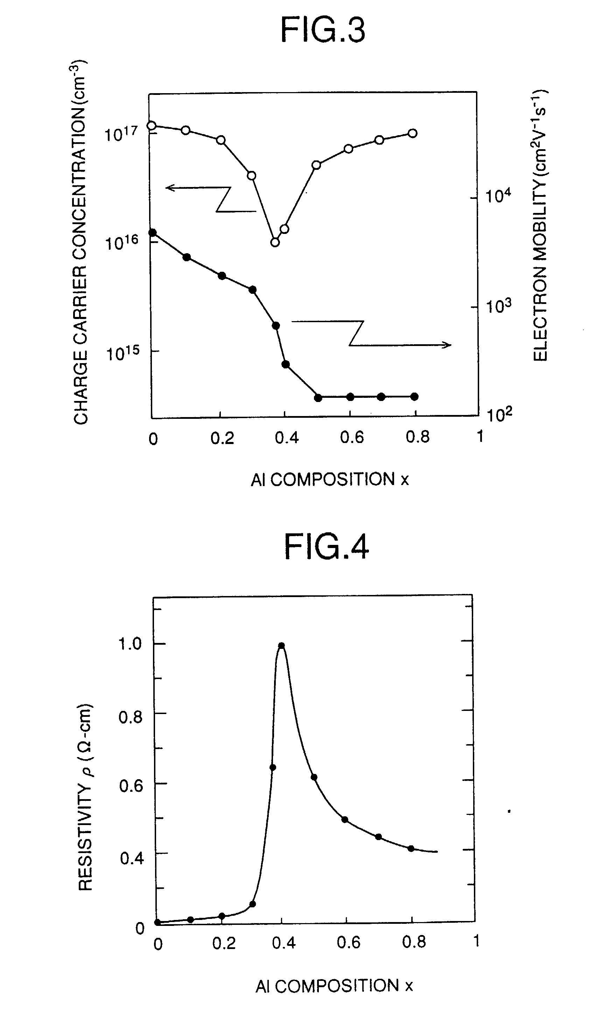

In the described structures, the Al composition x of the AlₓGa₁₋ₓAs ballast resistor layer has a preferred range. Fig.3 is a graph showing the charge carrier concentration and the electron mobility of an n-type AlₓGa₁₋ₓAs semiconductor layer as a function of x at room temperature. Figure 4 is a graph of the resistivity of n-type AlₓGa₁₋ₓAs as a function of x. When a donor impurity, such as silicon, is incorporated in the AlₓGa₁₋ₓAs layer, the charge carrier concentration varies depending upon the Al composition x. The charge carrier concentration is lowest when x is approximately 0.4. At higher or lower Al compositions, the charge carrier concentration increases. As shown in Fig.3, electron mobility gradually decreases as the Al composition x increases, declines drastically when the Al composition x reaches about 0.4, and settles to an almost constant value when x is about 0.5 or higher. The resistivity is inversely proportional to the product of the charge carrier concentration and mobility. Therefore, as shown in Fig.4, the resistivity has a peak value when the Al composition x is about 0.4. The resistivity gradually decreases at higher values of x and is constant or very low when x is not larger than 0.2. Thus, the resistivity varies very rapidly for a small change in Al composition when that Al composition x equals about 0.4, making control of the resistivity of the ballast resistor layer 9 difficult.

According to the aforementioned structure, since the Al composition x is limited to the range of 0.5 ≤ x ≤ 1, the resistivity of the ballast resistor layer 9 can be easily controlled during fabrication of HBTs. As a result, the yield of the HBTs can be improved. In addition, although the electron mobility is relatively low when x is at least 0.5, control of the resistance of a ballast resistor can be improved by increasing the charge carrier concentration in the manner described below.

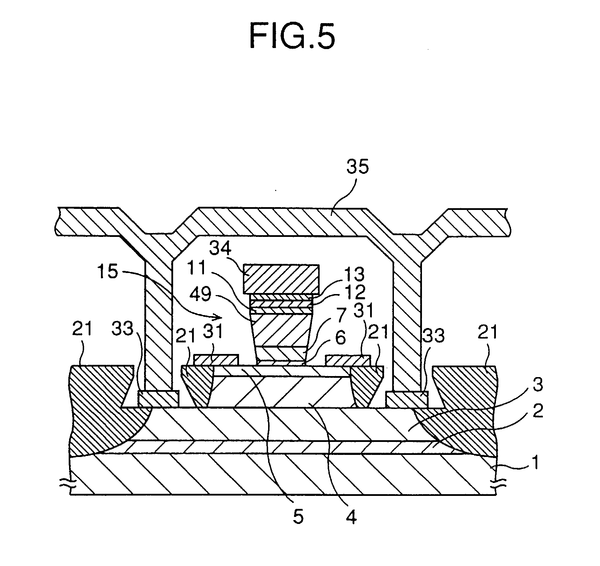

Fig.5 is a cross-sectional view of a part of a structure of a HBT for elucidating a further essential feature of the invention. This HBT includes an Al_{0.8}Ga_{0.2}As ballast resistor layer 49 having a thickness of 100 nm and doped to a charge carrier concentration of 2x10¹⁷ cm⁻³ at room temperature. Although this specific structure employs a particular Al concentration in and thickness of the ballast resistor layer 49, when the Al composition x is changed, the thickness of the layer must also be changed to produce the desired resistance of the ballast resistor for uniform operation of the unit transistors 15. The HBT shown in Fig.5 is fabricated in the same manner as described for the structure shown in Fig.1 except that the ballast resistor layer 49 is doped to produce a charge carrier concentration of 2x10¹⁷ cm⁻³ at room temperature. This charge carrier concentration provides improved performance, as described below.

Referring again to Fig.6, the charge carrier concentration for n-type AlₓGa₁₋ₓAs varies little with x and is generally proportional to the dopant concentration as long as the dopant concentration is at least 10¹⁷ cm⁻³. At dopant concentrations of 10¹⁶ cm⁻³ and below, charge carrier concentration falls drastically and control of that charge carrier concentration is difficult because of residual impurities in the material. Further, referring again to Fig.7, the deviation of resistivity likewise varies little with the Al composition x but varies very rapidly when the dopant concentration falls below about 10¹⁶ cm⁻³. Therefore, when the charge carrier concentration of the ballast resistor layer 49 is at least 10¹⁷ cm⁻³, the resistivity varies little with the Al composition, is easily controlled, and the variation of resistivity over a wafer face is reduced.

Fig.8 is a graph showing the resistivity for a wafer 40 using the structure shown in Fig.5 on which the n-type AlₓGa₁₋ₓAs ballast resistor layer has been grown. Open circles denote resistivities measured along a horizontal line in Fig.8 and darkened circles represent resistivities measured along a vertical line in Fig.8. As indicated in the graph, there is little variation in the resistivity as a function of position on the wafer 40.

According to the structure shown in Fig.5, since the charge carrier concentration in the n-type AlₓGa₁₋ₓAs ballast resistor layer 49, where 0.5 ≤ x ≤ 1, is at least 10¹⁷ cm⁻³, control of the resistance of the ballast resistor is improved. Moreover, since the uniformity of the resistivity on the wafer surface is improved, the reproducibility of the desired resistivity is improved, the yield is increased, and more reliable uniformity of operation of the unit transistors is achieved.

Fig.9 is a cross-sectional view of a unit HBT according to an embodiment of the invention. Since the same reference numbers are used in Fig.9 as in Fig.5 to identify identical elements, repeated description of those elements is not necessary. The structure according to the embodiment includes an n-type AlGaAs graded composition connection layer 8 having a dopant concentration of 10¹⁸ cm⁻³ and a thickness of 30 nm disposed between an n-type Al_{0,26}Ga_{0.74}As emitter layer 7 and an n-type Al_{0.8}Ga_{0.2}As ballast resistor layer 49. In the n-type AlGaAs connection layer 8, the Al composition gradually changes from 0.26 to 0.8. In the structure of Fig.9, an AlGaAs graded connection layer 10 having a dopant concentration of 10¹⁸ cm⁻³ and a thickness of 30 nm is disposed between the ballast resistor layer 49 and an n⁺-type GaAs spacer layer 11. In the connection layer 10, the Al composition gradually changes from 0.8 to 0.

As explained with reference to the structure shown in Fig.1 the Al composition x of the ballast resistor layer may be any value between 0.5 and 1. The Al compositions of the connection layer 8 and of the connection layer 10 at the interfaces of those layers with the ballast resistor layer 49 may vary and most preferably equal or substantially equal the Al composition of the ballast resistor layer. By matching the Al compositions at these interfaces, discontinuities in the energy band edges are reduced or eliminated at those interfaces. In addition, the matching of the energy band edges reduces the temperature dependency of the resistance of the ballast resistor. Moreover, the negative resistance phenomenon, described with respect to Fig.13, for a ballast resistor layer of n-type Al_{0.8}Ga_{0.2}As is prevented, resulting in uniform operation of the unit transistors 15.

In addition, the Al composition of the n-type AlGaAs layer 6 and the In composition of an n-type InGaAs layer 12 gradually change, i.e., layers 6 and 12 are compositionally graded, in the directions of the thicknesses of those layers. The graded layer 6 is provided to improve the gain of the transistor while the layer 12 is provided to reduce lattice mismatch between layers 11 and 13.

The method of producing the unit transistor of the embodiment is the same as the method employed in fabricating the unit transistor shown in Fig.3 except that the graded connection layers 8 and 10 are formed in the sequence of growing the semiconductor layers 6-13. The graded connection layers 8 and 10 can be grown by molecular beam epitaxy (MBE), for example, in which, even though the temperature of a Ga source is maintained constant, the temperature of the source of Al is gradually changed, producing a gradual change in the Al composition of the layer being grown.

## Claims

1. Heterojunction bipolar transistor, including:
a compound semiconductor emitter layer (7),
a semiconductor base layer (5),
a semiconductor collector layer (4),
an emitter electrode (34) being in electrical communication with said emitter layer (7),
a base electrode (31) being in electrical communication with said base layer (5),
a collector electrode (33) being in electrical communication with said collector layer (4), and
a ballast resistor layer (49) having a band gap energy and consisting of AlₓGa₁₋ₓAs being interposed between said emitter layer (7) and said emitter electrode (34),
*characterized in that*
said ballast resistor layer (49) having an Al composition of 0.5 ≤ x ≤ 1 and being doped to a charge carrier concentration of at least 10¹⁷ cm⁻³; and
a first graded composition connection layer (8) which contacts said ballast resistor layer (49) and serves for reducing the band gap difference, said first graded composition connection layer being interposed between said emitter layer (7) and said ballast resistor layer (49).

2. Transistor according to claim 1, *characterized in that* said first graded composition connection layer (8) has a composition and band gap energy varying between said emitter layer (7) and said ballast resistor layer (49) so that the band gap energy of said first graded composition connection layer (8) at said ballast resistor layer (49) is substantially equal to the band gap energy of said ballast resistor layer (49).

3. Transistor according to claim 2, *characterized in that* said first graded composition connection layer (8) consists of AlGaAs.

4. Transistor according to one of the claims 1 through 3, *characterized in that* a second graded composition connection layer (10) is interposed between said emitter electrode (34) and said ballast resistor layer (49) and serves for reducing the band difference.

5. Transistor according to claim 4, *characterized in that* said second graded composition connection layer (10) has a composition and band gap energy varying between said emitter electrode (34) and said ballast resistor layer (49) so that the band gap energy of said second graded composition connection layer (10) at said ballast resistor layer (49) is substantially equal to the band gap energy of said ballast resistor layer (49).

6. Transistor according to claim 5, *characterized in that* said second graded composition connection layer (10) consists of AlGaAs.

7. Heterojunction bipolar transistor including a plurality of unit transistors electrically connected in parallel,
*characterized in that*
each unit transistor is a heterojunction bipolar transistor according to one of the claims 1 through 6.

## Patentansprüche

1. Heteroübergangs-Bipolartransistor, der aufweist:
eine Verbindungshalbleiter-Emitterschicht (7),
eine Halbleiter-Basisschicht (5),
eine Halbleiter-Kollektorschicht (4),
eine Emitterelektrode (34), welche elektrisch mit der Emitterschicht (7) verbunden ist,
eine Basiselektrode (31), welche elektrisch mit der Basisschicht (5) verbunden ist,
eine Kollektorelektrode (33), welche elektrisch mit der Kollektorschicht (4) verbunden ist, und
eine eine Bandlückenenergie aufweisende und aus AlₓGa₁₋ₓAs bestehende Ballastwiderstandsschicht (49), die zwischen der Emitterschicht (7) und der Emitterelektrode (34) angeordnet ist,
*dadurch gekennzeichnet, daß*
die Ballastwiderstandsschicht (49) eine Al-Zusammensetzung von 0,5 ≤ x ≤ 1 aufweist und auf eine Ladungsträgerkonzentration von mindestens 10¹⁷ cm⁻³ dotiert ist; und
eine erste Verbindungsschicht (8) mit abgestufter Zusammensetzung, welche die Ballastwiderstandsschicht (49) berührt und dazu dient, die Bandlückendifferenz zu verringern, wobei sich die erste Verbindungsschicht mit abgestufter Zusammensetzung zwischen der Emitterschicht (7) und der Ballastwiderstandsschicht (49) befindet.

2. Transistor nach Anspruch 1, *dadurch gekennzeichnet, daß* die erste Verbindungsschicht (8) mit abgestufter Zusammensetzung eine Zusammensetzung und eine Bandlückenenergie aufweist, die sich zwischen der Emitterschicht (7) und der Ballastwiderstandsschicht (49) derart ändern, daß die Bandlückenenergie der ersten Verbindungsschicht (8) mit abgestufter Zusammensetzung an der Ballastwiderstandsschicht (49) im wesentlichen gleich der Bandlückenenergie der Ballastwiderstandsschicht (49) ist.

3. Transistor nach Anspruch 2, *dadurch gekennzeichnet, daß* die erste Verbindungsschicht (8) mit abgestufter Zusammensetzung aus AlGaAs besteht.

4. Transistor nach einem der Ansprüche 1 bis 3, *dadurch gekennzeichnet, daß* sich eine zweite Verbindungsschicht (10) mit abgestufter Zusammensetzung zwischen der Emitterelektrode (34) und der Ballastwiderstandsschicht (49) befindet und dazu dient, die Banddifferenz zu verringern.

5. Transistor nach Anspruch 4, *dadurch gekennzeichnet, daß* die zweite Verbindungsschicht (10) mit abgestufter Zusammensetzung eine Zusammensetzung und eine Bandlückenenergie aufweist, die sich zwischen der Emitterelektrode (34) und der Ballastwiderstandsschicht (49) derart ändern, daß die Bandlückenenergie der zweiten Verbindungsschicht (10) mit abgestufter Zusammensetzung an der Ballastwiderstandsschicht (49) im wesentlichen gleich der Bandlückenenergie der Ballastwiderstandsschicht (49) ist.

6. Transistor nach Anspruch 5, *dadurch gekennzeichnet, daß* die zweite Verbindungsschicht (10) mit abgestufter Zusammensetzung aus AlGaAs besteht.

7. Heteroübergangs-Bipolartransistor mit einer Vielzahl von elektrisch parallelgeschalteten Einheitstransistoren,
*dadurch gekennzeichnet, daß*
jeder Einheitstransistor ein Heteroübergangs-Bipolartransistor nach einem der Ansprüche 1 bis 6 ist.

## Revendications

1. Transistor bipolaire à hétérojonction, comprenant :
une couche d'émetteur semi-conductrice composée (7),
une couche semi-conductrice de base (5),
une couche semi-conductrice de collecteur (4),
une électrode d'émetteur (34) étant en communication électrique avec ladite couche d'émetteur (7),
une électrode de base (31) étant en communication électrique avec ladite couche de base (5),
une électrode de collecteur (33) étant en communication électrique avec ladite couche de collecteur (4), et
une couche de résistance de charge (49) présentant un écart énergétique et étant en AlₓGa₁₋ₓAs étant interposé entre ladite couche d'émetteur (7) et ladite électrode d'émetteur (34),
*caractérisé en ce que*
ladite couche de résistance de charge (49) ayant une composition Al de 0,5 = x = 1 et étant dopée à une concentration de porteur de charge d'au moins 10¹⁷ cm⁻³; et
une première couche de connexion à composition gradée (8), qui contacte ladite couche de résistance de charge (49) et sert à réduire la différence de l'écart énergétique, ladite première couche de connexion à composition gradée étant interposée entre ladite couche d'émetteur (7) et ladite couche de résistance de charge (49).

2. Transistor selon la revendication 1, *caractérisé en ce que* ladite première couche de connexion à composition gradée (8) a une composition et un écart énergétique variant entré ladite couche d'émetteur (7) et ladite couche de résistance de charge (49) de manière que l'écart énergétique de ladite première couche de connexion à composition gradée (8) à ladite couche de résistance de charge (49) est essentiellement égal à l'écart énergétique de ladite couche de résistance de charge (49).

3. Transistor selon la revendication 2, *caractérisé en ce que* ladite première couche de connexion à composition gradée est en AlGaAs.

4. Transistor selon l'une quelconque des revendications 1 à 3, *caractérisé en ce qu'*une seconde couche de connexion à composition gradée (10) est interposée entre ladite électrode d'émetteur (34) et ladite couche de résistance de charge (49) et sert à réduire la différence de bande.

5. Transistor selon la revendication 4, *caractérisé en ce que* ladite seconde couche de connexion à composition gradée (10) a une composition et un écart énergétique variant entre ladite électrode d'émetteur (34) et ladite couche de résistance de charge (49) de manière que l'écart énergétique de ladite seconde couche de connexion à composition gradée (10) à ladite couche de résistance de charge (49) est essentiellement égal à l'écart énergétique de ladite couche de résistance de charge (49).

6. Transistor selon la revendication 5, *caractérisé en ce que* ladite seconde couche de connexion à composition gradée est en AlGaAs.

7. Transistor bipolaire à hétérojonction comprenant une pluralité de transistors unitaires électriquement connectés en parallèle,
*caractérisé en ce que*
chaque transistor unitaire est un transistor bipolaire à hétérojonction selon l'une quelconque des revendications 1 à 6.
